(19) **Europäisches Patentamt**

**European Patent Office**

**Office européen des brevets**

(11) **EP 0 866 497 A2**

(12) **EUROPEAN PATENT APPLICATION**

(43) Date of publication:
**23.09.1998 Bulletin 1998/39**

(51) Int Cl.[6]: **H01L 21/66**

(21) Application number: **98301793.0**

(22) Date of filing: **11.03.1998**

| | |
|---|---|
| (84) Designated Contracting States:<br>**AT BE CH DE DK ES FI FR GB GR IE IT LI LU MC NL PT SE**<br>Designated Extension States:<br>**AL LT LV MK RO SI** | (72) Inventor: **Toyama, Kohei**<br>**Shirakawa-shi, Fukushima-ken (JP)** |
| (30) Priority: **17.03.1997 JP 83323/97** | (74) Representative: **Cooper, John et al**<br>**Murgitroyd & Company,**<br>**Chartered Patent Agents,**<br>**373 Scotland Street**<br>**Glasgow G5 8QA (GB)** |
| (71) Applicant: **SHIN-ETSU HANDOTAI COMPANY LIMITED**<br>**Chiyoda-ku Tokyo (JP)** | |

(54) **Method and system for controlling manufacturing steps in the manufacture of monocrystalline semiconductor silicon wafers**

(57)     There is disclosed a method and system of controlling manufacturing steps in the manufacture of monocrystalline semiconductor silicon wafers. In a main manufacturing process in which wafers obtained by slicing an ingot undergo the manufacturing steps of lapping, chamfering, etching, mirror-polishing, cleaning, inspection, and shipment, a stocker for temporarily storing wafers is disposed to perform hot control based on a hot measured in wafer units. The method and system improve productivity and quality.

FIG. 1

## Description

BACKGROUND OF THE INVENTION

Field of the Invention:

The present invention relates to a method of controlling manufacturing steps for controlling the flow of raw material, semifinished products, and finished products in a process of manufacturing monocrystalline semiconductor silicon wafers from monocrystalline semiconductor silicon ingots, as well as to a system of controlling manufacturing steps in the process.

Description of the Related Art:

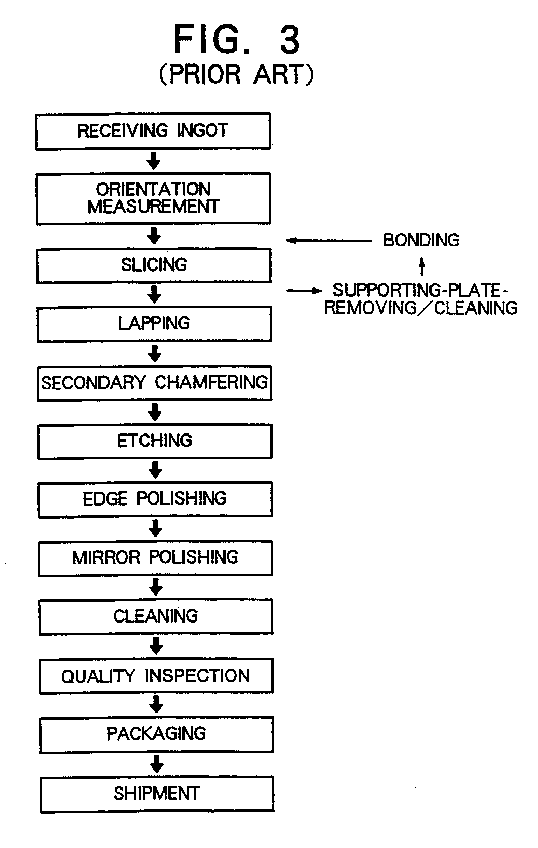

Conventionally, monocrystalline semiconductor silicon wafers have been manufactured in a manner as shown in FIG. 3 which shows major manufacturing steps thereof. An incoming ingot undergoes a series of steps of slicing, lapping, chamfering, etching, mirror-polishing, and cleaning, whereby wafers are obtained. Further, the thus-obtained wafers undergo the steps of inspection, quality assurance, packaging, and the like and are then shipped. Also, various sub-steps are performed between these steps. The order of the steps is not limited to that of FIG. 3, but is modified according to purpose.

In the conventional wafer-manufacturing process, slicing is first performed on the basis of an ingot. That is, a single ingot is handled as a single lot for processing. Accordingly, the lot size varies significantly according to the length of the ingot. Further, the lot size is as large as several hundreds to one thousand wafers. By contrast, in the steps subsequent to the slicing step, the processing-batch size is as small as a single wafer to tens of wafers and varies among the steps. Thus, a manufacturing step having the smallest processing-batch size per unit time serves as a rate-determining step, and the processing rate is dependent on the smallest processing-batch size. As a result, in the processing of a single lot, the flow of wafers is stagnant between manufacturing steps, or, on the contrary, idle time due to no flow of wafers arises therebetween. Thus, efficient control of manufacturing steps has not always been carried out.

Also, since processing is conducted on the basis of an ingot, wafers obtained from a plurality of ingots cannot be mixedly handled within a single process, and the processing rate of each manufacturing step cannot be adjusted.

SUMMARY OF THE INVENTION

The present invention has been accomplished to solve the above-mentioned problems, and an object of the invention is to provide a method and system for controlling manufacturing steps in the manufacture of monocrystalline semiconductor silicon wafers, enabling the prevention of a stagnant or no flow of wafers between manufacturing steps and enabling the mixed processing of wafers obtained from a plurality of ingots to thereby improve the operation rate of manufacturing steps and stabilize operation.

To achieve the above object, according to a first aspect of the present invention, there is provided a method of controlling manufacturing steps in the manufacture of monocrystalline semiconductor silicon wafers, which method comprises the step of performing control based on a lot measured in wafer units through use of a stocker for temporarily storing wafers in a main manufacturing process in which wafers obtained by slicing an ingot undergo the manufacturing steps of lapping, chamfering, etching, mirror-polishing, cleaning, inspection, and shipment, whereby monocrystalline semiconductor silicon wafers are manufactured.

Through use of a stocker provided between manufacturing steps for temporarily storing wafers, control can be performed based on a lot measured in wafer units, as opposed to an ingot lot. Control based on a lot measured in wafer units can absorb the difference in processing capability between manufacturing steps, thereby enabling a constant rate of processing in the entire manufacturing process. Also, wafers stored in a stocker are subjected to processing in a sub-process disposed in parallel with the stocker to thereby reduce or eliminate waiting time.

Stockers may be respectively disposed at least somewhere after the slicing step and somewhere before the shipment step. Alternatively, stockers may be respectively disposed at least after the supporting-plate-removing/cleaning step subsequent to the slicing step and before the final cleaning step.

By respectively disposing stockers after the slicing step and before the shipment step, control based on a lot measured in wafer units is enabled subsequent to the slicing step in which an ingot is sliced into a large number of wafers. Further, in the main manufacturing process, by disposing a stocker after a manufacturing step having a relatively high processing capability or before a manufacturing step having a relatively low processing capability, the stocker can be used as a buffer, whereby wafers can be processed more efficiently and at a constant rate in the main manufacturing process.

When among manufacturing steps in the main manufacturing process, a first step A has a processing-batch size of "a" wafers, step B has a processing-batch size of "b" wafers ..., and the final step F has a processing-batch size of "f" wafers, control is preferably performed such that the least common multiple of the processing-batch sizes a (wafers) through f (wafers) of the manufacturing steps A through F is taken as the size L (wafers) of an inter-step lot.

When the greatest common divisor of the processing-batch sizes of the manufacturing steps is represented by G (wafers), a cassette which accommodates at least G wafers is preferably regarded as the minimum lot and the G wafers in the cassette are transported into and out of a manufacturing step, subjected to a processing, and loaded into, stored in, and unloaded from a stocker; and the wafer-processing rates of entire manufacturing steps are preferably controlled or managed such that the minimum lot (G wafers) serves as a sub-lot of the inter-step lot (L wafers).

Since the size of a lot for processing wafers is determined as described above to thereby organize a lot, the form of control can be shifted from control based on a lot measured in an ingot to control based on a lot measured in predetermined wafer units. Accordingly, the processing rate of each manufacturing step can be flexibly coped with, whereby wafers can be efficiently processed at a constant rate in the all manufacturing process.

Wafers stored in the stocker are preferably subjected to processing in a sub-process disposed in parallel with the main manufacturing process on the basis of the minimum lot (G wafers), and then the minimum lot is preferably reorganized. Further, the sub-process preferably includes the step of measuring crystal orientation, inspecting quality, and/or chamfering.

Employment of the stocker and the sub-process enables the smooth flow of wafers in the main manufacturing process on the basis of the minimum lot (G wafers) from one manufacturing step to the subsequent manufacturing step with no involvement of stagnation or idle time of wafer flow and enables wafers contained in the stocker to undergo processing which has been conventionally incorporated in the main manufacturing process, with no loss of time in the sub-process.

When S wafers are sliced from a single ingot and nG represents integral multiples of the size G (wafers) of the minimum lot, the number R of fractional wafers unable to constitute a regular lot is expressed by

$$R = (S - nG)$$

where S is greater than nG; and fractional wafers $R_a$, $R_b$, ... and $R_f$ generated from respective ingots are preferably fed to the main manufacturing process as dummy wafers.

Thus, the generation of fractional wafers is minimized, thereby improving the yield of product wafers, enabling the prompt setting of processing conditions, and improving the efficiency of lot-based control.

The method of controlling manufacturing steps of the invention is preferably applied to the case where a multi-wire saw serves as a slicing apparatus used in the slicing step for slicing an ingot. Since the multi-wire saw slices an ingot into a large number of wafers at a time, the method is useful for improving the productivity and yield of product wafers.

According to a second aspect of the present invention, there is provided a system of controlling manufacturing steps in the manufacture of monocrystalline semiconductor silicon wafers, which system comprises a stocker for temporarily storing wafers so as to perform lot control based on a lot measured in wafer units in a main manufacturing process in which wafers obtained by slicing an ingot undergo the manufacturing steps of lapping, chamfering, etching, mirror-polishing, cleaning, inspection, and shipment, whereby monocrystalline semiconductor silicon wafers are manufactured.

Through use of a stocker provided between manufacturing steps for temporarily storing wafers, control can be performed based on a lot measured in wafer units, not an ingot lot. Control based on a lot measured in wafer units can absorb the difference in processing capability between manufacturing steps, thereby enabling a constant rate of processing in the entire manufacturing process. Also, wafers stored in a stocker are subjected to processing in a sub-process disposed in parallel with the stocker to thereby reduce or eliminate waiting time.

Stockers may be respectively disposed at least somewhere after the slicing step and somewhere before the shipment step. Alternatively, stockers may be respectively disposed at least after the supporting-plate-removing/cleaning step subsequent to the slicing step and before the final cleaning step.

By respectively disposing stockers after the slicing step and before the shipment step, control based on a lot measured in wafer units is enabled subsequent to the slicing step in which an ingot is sliced into a large number of wafers. Further, in the main manufacturing process, by disposing a stocker after a manufacturing step having a relatively high processing capability or before a manufacturing step having a relatively low processing capability, the stocker can be used as a buffer, whereby wafers can be processed more efficiently and at a constant rate in the main manufacturing process.

When among manufacturing steps in the main manufacturing process, a first step A has a processing-batch size of "a" wafers, step B has a processing-batch size of "b" wafers ..., and the final step F has a processing-batch size of "f" wafers, control is preferably performed such that the least common multiple of the processing-batch sizes a (wafers) through f (wafers) of the manufacturing steps A through F is taken as the size L (wafers) of an inter-step lot.

When the greatest common divisor of the processing-batch sizes of the manufacturing steps is represented by G (wafers), a cassette which accommodates at least G wafers is preferably regarded as the minimum lot and the G wafers in the cassette are transported into and out of a manufacturing step, subjected to a machining processing, and loaded into, stored in, and unloaded from a stocker; and the wafer-processing rates of the entire manufacturing steps are preferably controlled or managed such that the minimum lot (G wafers) serves as a sub-lot of the inter-step lot (L wafers).

Since the size of a lot for processing wafers is determined as described above to thereby organize a lot, the form of control can be shifted from control based on a lot measured in an ingot to control based on a lot measured in predetermined wafer units. Accordingly, the processing rate of each manufacturing step can be flexibly coped with, whereby wafers can be efficiently processed at a constant rate in the entire manufacturing process.

Wafers stored in the stocker are preferably subjected to processing in a sub-process disposed in parallel with the main manufacturing process on the basis of the minimum lot (G wafers), and then the minimum lot is preferably reorganized. Further, the sub-process preferably includes the step of measuring crystal orientation, inspecting quality, and/or chamfering.

Employment of the stocker and the sub-process enables the smooth flow of wafers in the main manufacturing process on the basis of the minimum lot (G wafers) from one manufacturing step to the subsequent manufacturing step with no involvement of stagnation or idle time of wafer flow and enables wafers contained in the stocker to undergo processing which has conventionally been incorporated in the main manufacturing process, with no loss of time in the sub-process.

When S wafers are sliced from a single ingot and nG represents integral multiples of the size G (wafers) of the minimum lot, the number R of fractional wafers unable to constitute a regular lot is expressed by

$$R = (S - nG)$$

where S is is greater than nG; and fractional wafers $R_a$, $R_b$, ... and $R_f$ generated from respective ingots are preferably fed to the main manufacturing process as dummy wafers.

Thus, the generation of fractional wafers is minimized, thereby improving the yield of product wafers, enabling the prompt setting of processing conditions, and improving the efficiency of lot-based control.

The system of controlling manufacturing steps of the invention is preferably applied to the case where a multi-wire saw serves as a slicing apparatus used in the slicing step for slicing an ingot. Since a multi-wire saw slices an ingot into a large number of wafers at a time, the system is useful for improving the productivity and yield of product wafers.

According to the present invention, a stocker is disposed between manufacturing steps in the main manufacturing process so as to control the flow of wafers based on a lot measured in wafer units, thereby preventing a stagnant or no flow of wafers between manufacturing steps and attaining a constant processing rate. Also, there are employed two kinds of sizes of a lot for processing, i.e. an inter-step lot and a minimum lot. Accordingly, wafers obtained from a plurality of ingots can be mixedly processed based on respective minimum lots. Further, a sub-process is disposed in parallel with a stocker for the purpose of secondary processing and quality inspection. Thus, the productivity of the entire manufacturing process is improved; yield is improved; operation is stabilized; and thorough quality control is performed.

BRIEF DESCRIPTION OF THE DRAWINGS

FIG. 1 is a flowchart showing the steps of manufacturing monocrystalline semiconductor wafers according to the present invention;
FIG. 2 is a schematic diagram showing an example of flow of wafers within a single manufacturing step (edge polishing step) in the flowchart of FIG. 1; and
FIG. 3 is a flowchart showing an example of the steps of manufacturing monocrystalline semiconductor wafers in a conventional wafer-manufacturing system.

DESCRIPTION OF THE PREFERRED EMBODIMENT

An embodiment of the present invention will now be described in detail with reference to the drawings. However, the present invention is not limited to the embodiment.

In a conventional method and system of controlling manufacturing steps in the manufacture of monocrystalline semiconductor silicon wafers, a single ingot is handled as a single lot for processing, and wafers sliced from the ingot serially undergo a plurality of processes in a predetermined sequence. Accordingly, the flow of wafers is difficult to cope with variations in the size of a processing batch among manufacturing steps. That is, processing in manufacturing steps proceeds at the processing rate of a manufacturing step having the smallest processing-batch size, indicating that control of manufacturing steps is performed in a very inefficient manner. In order to improve such inefficient control of manufacturing steps, the inventors of the present invention have taken an approach of disposing a stocker for temporarily storing wafers between manufacturing steps so as to control the flow of wafers based on a lot measured in wafer units, for example, on the basis of a cassette, thus accomplishing the present invention.

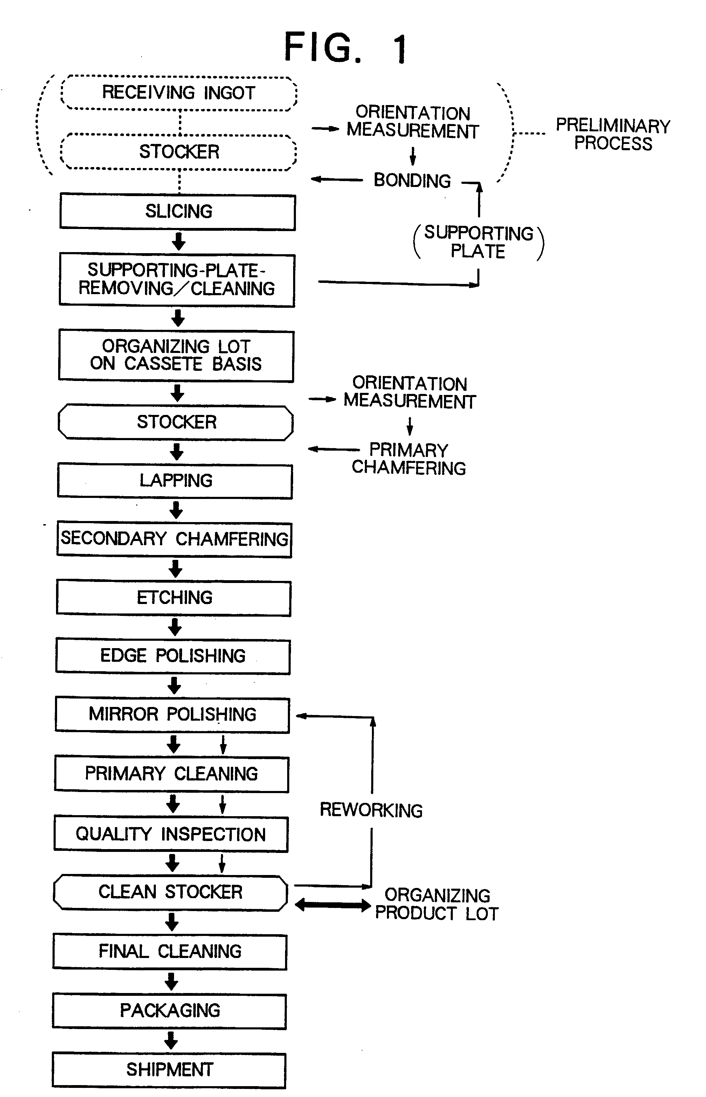

FIG. 1 exemplifies the steps of manufacturing monocrystalline semiconductor silicon wafers according to the present invention.

First, in the preliminary process of the present invention, a monocrystalline silicon ingot is fed into a wafer-manufacturing system upon reception of an order from a customer, the ingot is marked with an order No. and an ingot lot No., and the thus-marked ingot is stored in a stocker for an ingot until an instruction to deliver the ingot to the subsequent slicing step is issued. While the ingot is stored in the stocker, the ingot undergo processing in a sub-process disposed in parallel with the stocker in preparation for slicing. Specifically, in the sub-process, the ingot undergoes measurement of crystal orientation, and a supporting plate and a workpiece plate are bonded to the ingot to prevent wafers from dropping during slicing. The thus-treated ingot is brought back to the stocker and stored therein.

When an instruction of delivery is issued from a computer, the ingot is fed to the slicing step, in which the ingot is sliced to obtain a block of wafers which is determined for the ingot.

Next will be described the concept of a lot used in control of manufacturing steps according to the present invention. The above-mentioned block corresponds to an inter-step lot, which is defined as follows.

When among manufacturing steps in the main manufacturing process, a first step A has a processing-batch size of "a" wafers, step B has a processing-batch size of "b" wafers ..., and the final step F has a processing-batch size of "f" wafers, the least common multiple of the processing-batch sizes a (wafers) through f (wafers) of the manufacturing steps A through F is taken as the size L (wafers) of an inter-step lot.

When the greatest common divisor of the processing-batch sizes of the manufacturing steps is represented by G (wafers), the wafer-processing rates of manufacturing steps are controlled or managed such that a cassette which accommodates at least G wafers serves as the minimum lot for loading wafers into or unloading from a manufacturing step, for processing wafers, or for loading wafers into, storing wafers in, or unloading wafers from a stocker and that the minimum lot (G wafers) serves as a sub-lot in relation to an inter-step lot (L wafers).

The above-described lot organization and the disposition of a stocker described below enable processing of wafers even when blocks, i.e., inter-step lots obtained from a plurality of ingots are mixedly present or when minimum lots are mixedly present. Thus, as compared with a conventional control method or system in which a single ingot serves as a single lot, wafers flow smoothly on the basis of the minimum lot from one manufacturing step to the subsequent manufacturing step with no involvement of stagnation or idle time of wafer flow, thereby significantly improving the processing rate, stabilizing operation, and improving efficiency of operation and thus improving the yield of product wafers.

A supporting plate and a workpiece plate are removed from wafers obtained by slicing an ingot. After being cleaned, wafers are organized into minimum lots according to the above-described lot-organizing method and stored in a stocker.

Another feature of the present invention is to employ a stocker for temporarily storing wafers to thereby control wafer flow based on a lot measured in wafer units.

A stocker is disposed between manufacturing steps having such a difference in batch-processing capability that allows wafers to undergo secondary processing, sampling inspection of quality, or the like while cassettes are stagnant between the steps due to the difference in batch-processing capability. Stockers are respectively disposed at least somewhere after the slicing step and somewhere before the shipment step. Particularly preferably, at least, a cassette stocker is disposed after the supporting plate-removing/cleaning step subsequent to the slicing step, and a clean stocker is disposed before the final cleaning step. The cassette stocker is the starting point of control on the basis of the minimum lot. The clean stocker is the place where a product lot is organized immediately before shipment.

A sub-process disposed in parallel with the cassette stocker is composed of, for example, a crystal orientation measurement step and a primary chamfering step. A sub-process disposed in parallel with the clean stocker is composed of, for example, a compiling step for reorganizing product wafers into a product lot for shipment. The disposition of such sub-processes improves the productivity of the wafer-manufacturing system.

After undergoing measurement of crystal orientation and primary chamfering in the sub-process during storage in the cassette stocker, wafers are transferred on the basis of the inter-step lot through the main manufacturing process encompassing the manufacturing steps of lapping, secondary chamfering, etching, edge polishing, mirror polishing (primary polishing, secondary polishing, and final polishing), primary cleaning, and inspection. In each manufacturing step, wafers are processed on the basis of the minimum lot. Wafers delivered from the inspection step are stored in the clean stocker.

In the clean stocker, wafers are judged acceptable or not acceptable from the result of quality inspection conducted in accordance with the product standard. Rejected wafers are organized into a minimum lot and sent back to the mirror polishing step to be mirror-polished again. Accepted wafers are reorganized into a minimum lot in the sub-process, and subsequently transferred through the main manufacturing process encompassing the manufacturing steps of final cleaning, packaging, and shipment. Accepted wafers delivered from the shipment step are sent to a customer.

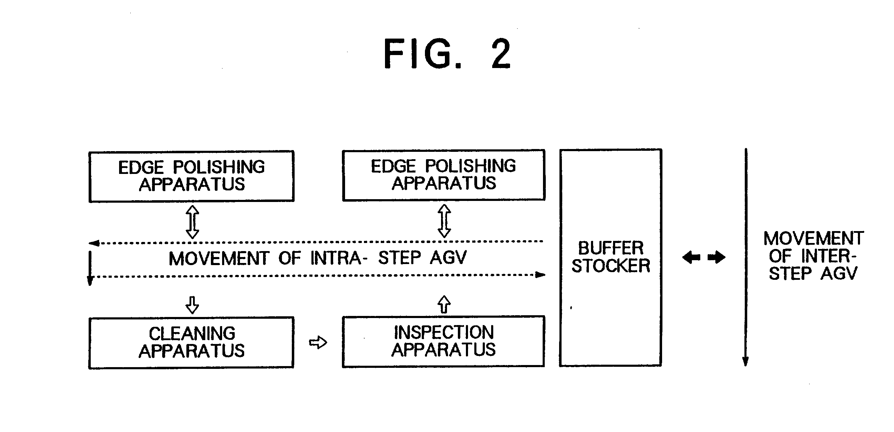

Each of the manufacturing steps is self-sufficient and employs the system that wafers are received and delivered in a cassette. For example, as shown in FIG. 2, in the edge polishing step, a buffer stocker is disposed at the entrance to the step. Wafers delivered from the preceding etching process are transferred on the basis of the inter-step lot to the buffer stocker by an inter-step AGV (Automatic Guided Vehicle) and stored in the buffer stocker. In the edge polishing step, a predetermined cassette is unloaded from the buffer stocker and loaded onto an intra-step AGV. The thus-unloaded cassette is then set in an edge polishing apparatus so that wafers undergo edge polishing on the basis of a cassette. Then, edge polished wafers undergo cleaning and intra-step inspection on the basis of a cassette and then stored again in the buffer stocker. In the edge polishing step, a cassette is timely transferred by an intra-step AGV so as to correspond to the progress of processing within the step.

When S wafers are sliced from a single ingot in the preceding slicing step and nG represents integral multiples of the size G (wafers) of the minimum lot, the number R of fractional wafers unable to constitute a regular lot is expressed by

$$R = (S - nG)$$

where S is greater than nG. Fractional wafers $R_a$, $R_b$, ... and $R_f$ generated from respective ingots are fed to the main manufacturing process as dummy wafers to thereby reduce wafer loss. Dummy wafers are effectively utilized for setting or adjusting processing conditions.

Hardware applied to the method and system of controlling manufacturing steps of the present invention includes known independent processing apparatuses, such as an inner diameter slicer, a multi-wire saw, a lapping machine, an etching apparatus, a polishing machine, and a cleaning apparatus; a conveyance apparatuses in the combined form of a belt conveyor, a roller conveyor, a turntable, an automatic connectable uncoupling transfer vehicle, a handling robot, and the like; and automatic operation control devices such as position sensors, timers, and a control computer. They are combined, as needed to thereby form a so-called AGV (Automatic Guided Vehicle) system.

As a slicing apparatus used in the slicing step for slicing an ingot, an inner diameter slicer has been dominantly used, but is being replaced by a multi-wire saw having high productivity since the inner diameter slicer cannot follow the trend toward an increase in ingot diameter. The present invention is intended to improve productivity through sufficient utilization of characteristics and capability of a multi-wire saw to thereby reduce loss of wafers and time as much as possible.

Through use of a multi-wire saw in the slicing step, a large number of wafers are obtained at a time by slicing. Thus, in such a case, the control system of the present invention is particularly useful because control is performed based on a lot measured in wafer units.

A stocker may be of any type so long as a commercially available cassette is properly loaded thereinto or unloaded therefrom. The shelf type, drawer type, box type, or the like may be selected according to characteristics of the above-mentioned independent processing apparatuses and conveyance apparatuses to be employed. When wafers are to be stored in a stocker for relatively long time, the stocker must employ appropriate measures for sustaining appropriate cleanliness.

EXAMPLES

The present invention will next be described by way of example, which should not be construed as limiting the invention.

Examples:

The processing-batch size of the manufacturing step A was 20 wafers, that of the manufacturing step B was 15 wafers, and those of other manufacturing steps were 10 wafers. The size L of the inter-step lot, which is the least common multiple of these processing-batch sizes, was 60 wafers. The size G of the minimum lot, which is the greatest common divisor of these processing-batch sizes, was 10 wafers. In the main manufacturing process composed of the manufacturing steps and accompanied by a sub-process, wafers were processed under the following lot organization: main lot: 60 wafers; sub-lot: 10 wafers. As shown in FIG. 1, a cassette stocker was disposed between the supporting-plate-removing/cleaning step and the lapping step, and a clean stocker was disposed between the final inspection step and the final cleaning step. Measurement of crystal orientation and primary chamfering were carried out in the sub-process disposed in parallel with the cassette stocker, and a lot was reorganized in the sub-process disposed in parallel with the clean stocker.

As a Comparative Example, an ingot and wafers were processed as a single lot according to the conventional flow of processing as shown in FIG. 3, in which no stocker is employed.

Test operation revealed that in the Comparative Example, the lead time ranging from reception of an ingot to shipment of wafers was 14 days (days of operation), whereas in the Example of the present invention, the lead time was 8.5 days (days of operation), approximately 60% of that of the Comparative Example.

The present invention is not limited to the above-described embodiment. The above-described embodiment is a mere example, and those having the substantially same structure as that described in the appended claims and providing the similar action and effects are included in the scope of the present invention.

For example, the above embodiment is described while mentioning a cassette stocker and a clean stocker disposed in the main manufacturing process as well as mentioning a buffer stocker disposed in the edge polishing step as an example of a stocker disposed in a sub-process. Also, according to the description, the disposition of the cassette and clean stockers is not combined with the disposition of the buffer stocker. However, these stockers may be disposed in combination with each other. Further, the position or number of stockers to be disposed may be freely modified. When the batch-processing capability of a processing machine in a certain manufacturing step is changed, the disposition of a buffer stocker will significantly improve the flow of wafers. In such a case, the position or number of buffer stockers to be disposed can be flexibly determined.

Also, the present invention is described while mentioning the manufacturing steps of lapping, chamfering, etching, mirror polishing, cleaning, inspection, and shipment as steps for manufacturing monocrystalline silicon wafers. However, these steps are mentioned as mere examples. The present invention is not limited to the order and employment of the manufacturing steps. Various other steps may be present among the manufacturing steps. Also, according to purpose, the order of the manufacturing steps may be modified, or some of the manufacturing steps may be omitted. Needless to say, the scope of the present invention encompasses modifications.

## Claims

1. A method of controlling manufacturing steps in the manufacture of monocrystalline semiconductor silicon wafers, characterized in that in a main manufacturing process in which wafers obtained by slicing an ingot undergo the manufacturing steps of lapping, chamfering, etching, mirror-polishing, cleaning, inspection, and shipment, a stocker for temporarily storing wafers is provided to perform lot control based on a lot measured in wafer units.

2. A method of controlling manufacturing steps in the manufacture of monocrystalline semiconductor silicon wafers according to Claim 1, characterized in that stockers are respectively disposed at least somewhere after the slicing step and somewhere before the shipment step.

3. A method of controlling manufacturing steps in the manufacture of monocrystalline semiconductor silicon wafers according to Claim 1 or 2, characterized in that stockers are respectively disposed at least after a supporting-plate-removing/cleaning step subsequent to the slicing step and before a final cleaning step.

4. A method of controlling manufacturing steps in the manufacture of monocrystalline semiconductor silicon wafers according to any one of Claims 1 - 3, characterized in that when among manufacturing steps in the main manufacturing process, a first step A has a processing-batch size of "a" wafers, step B has a processing-batch size of "b" wafers ..., and the final step F has a processing-batch size of "f" wafers, the size L (wafers) of an inter-step lot is determined to equal to the least common multiple of the processing-batch sizes a (wafers) through f (wafers) of the manufacturing steps A through F.

5. A method of controlling manufacturing steps in the manufacture of monocrystalline semiconductor silicon wafers according to Claim 4, characterized in that when the greatest common divisor of the processing-batch sizes of the manufacturing steps is represented by G (wafers), a cassette which accommodates at least G wafers is regarded as the minimum lot and the G wafers in the cassette are transported into and out of a manufacturing step, subjected to a machining processing, and loaded into, stored in, and unloaded from a stocker; and the wafer-processing rates of manufacturing steps are controlled or managed such that the minimum lot (G wafers) serves as a sub-lot of the inter-step lot (L wafers).

6. A method of controlling manufacturing steps in the manufacture of monocrystalline semiconductor silicon wafers according to Claim 5, characterized in that wafers stored in the stocker are subjected to processing in a sub-process disposed in parallel with the main manufacturing process on the basis of the minimum lot (G wafers), and the minimum lot is then reorganized.

7. A method of controlling manufacturing steps in the manufacture of monocrystalline semiconductor silicon wafers according to Claim 6, characterized in that the sub-process includes at least one of measuring crystal orientation, inspecting quality, and chamfering.

8. A method of controlling manufacturing steps in the manufacture of monocrystalline semiconductor silicon wafers according to any one of Claims 1- 7, characterized in that when S wafers are sliced from a single ingot and nG represents integral multiples of the size G (wafers) of the minimum lot, the number R of fractional wafers unable to constitute a regular lot is expressed by

$$R = (S - nG)$$

where S is greater than nG; and fractional wafers $R_a$, $R_b$, ... and $R_f$ generated from respective ingots are fed to the main manufacturing process as dummy wafers.

9. A method of controlling manufacturing steps in the manufacture of monocrystalline semiconductor silicon wafers according to any one of Claims 1 - 8, characterized in that a multi-wire saw serves as a slicing apparatus used in the slicing step for slicing an ingot.

10. A system of controlling manufacturing steps in the manufacture of monocrystalline semiconductor silicon wafers, characterized in that in a main manufacturing process in which wafers obtained by slicing an ingot undergo the manufacturing steps of lapping, chamfering, etching, mirror-polishing, cleaning, inspection, and shipment, a stocker for temporarily storing wafers is disposed so as to perform lot control based on a lot measured in wafer units.

11. A system of controlling manufacturing steps in the manufacture of monocrystalline semiconductor silicon wafers according to Claim 10, characterized in that stockers are respectively disposed at least somewhere after the slicing step and somewhere before the shipment step.

12. A system of controlling manufacturing steps in the manufacture of monocrystalline semiconductor silicon wafers according to Claim 10 or 11, characterized in that stockers are respectively disposed at least after a supporting-plate-removing/cleaning step subsequent to the slicing step and before a final cleaning step.

13. A system of controlling manufacturing steps in the manufacture of monocrystalline semiconductor silicon wafers according to any one of Claim 10 - 12, characterized in that when among manufacturing steps in the main manufacturing process, a first step A has a processing-batch size of "a" wafers, step B has a processing-batch size of "b" wafers ..., and the final step F has a processing-batch size of "f" wafers, the size L (wafers) of an inter-step lot is determined to equal to the least common multiple of the processing-batch sizes a (wafers) through f (wafers) of the manufacturing steps A through F.

14. A system of controlling manufacturing steps in the manufacture of monocrystalline semiconductor silicon wafers according to Claim 13, characterized in that when the greatest common divisor of the processing-batch sizes of the manufacturing steps is represented by G (wafers), a cassette which accommodates at least G wafers is regarded as the minimum lot and the G wafers in the cassette are transported into and out of a manufacturing step, subjected to a machining processing, and loaded into, stored in, and unloaded from a stocker; and the wafer-processing rates of manufacturing steps are controlled or managed such that the minimum lot (G wafers) serves as a sub-lot of the inter-step lot (L wafers).

15. A system of controlling manufacturing steps in the manufacture of monocrystalline semiconductor silicon wafers according to Claim 14, characterized in that wafers stored in the stocker are subjected to processing in a sub-process disposed in parallel with the main manufacturing process on the basis of the minimum lot (G wafers), and the minimum lot is then reorganized.

16. A system of controlling manufacturing steps in the manufacture of monocrystalline semiconductor silicon wafers according to Claim 15, characterized in that the sub-process includes at least one of measuring crystal orientation, inspecting quality, and chamfering.

17. A system of controlling manufacturing steps in the manufacture of monocrystalline semiconductor silicon wafers according to any one of Claims 10 - 16, characterized in that when S wafers are sliced from a single ingot and nG represents integral multiples of the size G (wafers) of the minimum lot, the number R of fractional wafers unable to constitute a regular lot is expressed by

$$R = (S - nG)$$

where S is greater than nG; and fractional wafers $R_a$, $R_b$, ... and $R_f$ generated from respective ingots are fed to the main manufacturing process as dummy wafers.

18. A system of controlling manufacturing steps in the manufacture of monocrystalline semiconductor silicon wafers any one of Claims 10 - 17, characterized by being applied to the case where a multi-wire saw serves as a slicing apparatus used in the slicing step for slicing an ingot.

# FIG. 1

```
┌ ─ ─ ─ ─ ─ ─ ─ ─ ─ ─ ─ ─ ─ ─ ─ ─ ─ ─ ─ ─ ┐
    ┌ · · · · · · · · · · · · · · · · · · · · · ┐
    :        RECEIVING INGOT        :              ORIENTATION
    └ · · · · · · · · · · · · · · · · · · · · · ┘          ──▶ MEASUREMENT              ····· PRELIMINARY
│            │                      │                        │                              PROCESS
    ┌ · · · · · │· · · · · · · · · · · · · ┐                    ▼
    :          STOCKER               :         ◀──        BONDING ┐
│   └ · · · · · │· · · · · · · · · · · · · ┘                        │
 ─ ─ ─ ─ ─ ─│─ ─ ─ ─ ─ ─ ─ ─ ─ ─ ─ ─ ─ ─                        │
            ▼                                        ⎛ SUPPORTING ⎞ │
    ┌───────────────────────┐                        ⎝   PLATE    ⎠
    │        SLICING         │                                      │
    └───────────┬───────────┘                                      │
                ▼                                                   │
    ┌───────────────────────┐                                      │
    │   SUPPORTING-PLATE-    │────────────────────────────────────┘
    │   REMOVING/CLEANING    │
    └───────────┬───────────┘
                ▼
    ┌───────────────────────┐
    │    ORGANIZING LOT      │
    │   ON CASSETE BASIS     │              ORIENTATION
    └───────────┬───────────┘          ──▶ MEASUREMENT
                ▼                           │
    ┌───────────────────────┐               ▼
    │        STOCKER         │         ◀──    PRIMARY
    └───────────┬───────────┘               CHAMFERING
                ▼
    ┌───────────────────────┐
    │        LAPPING         │
    └───────────┬───────────┘
                ▼
    ┌───────────────────────┐
    │  SECONDARY CHAMFERING  │
    └───────────┬───────────┘
                ▼
    ┌───────────────────────┐
    │        ETCHING         │
    └───────────┬───────────┘
                ▼
    ┌───────────────────────┐
    │     EDGE POLISHING     │
    └───────────┬───────────┘
                ▼
    ┌───────────────────────┐
    │    MIRROR POLISHING    │◀──────────┐
    └─────────┬─┬───────────┘            │
              ▼ ▼                        │
    ┌───────────────────────┐            │
    │    PRIMARY CLEANING    │           REWORKING
    └─────────┬─┬───────────┘            │
              ▼ ▼                        │
    ┌───────────────────────┐            │
    │   QUALITY INSPECTION   │            │
    └─────────┬─┬───────────┘            │
              ▼ ▼                        │
    ┌───────────────────────┐            │
    │     CLEAN STOCKER      │────────────┘
    └───────────┬───────────┘         ═══▶  ORGANIZING
                ▼                            PRODUCT LOT
    ┌───────────────────────┐
    │     FINAL CLEANING     │
    └───────────┬───────────┘
                ▼
    ┌───────────────────────┐
    │       PACKAGING        │
    └───────────┬───────────┘
                ▼
    ┌───────────────────────┐
    │        SHIPMENT        │
    └───────────────────────┘
```

# FIG. 2

EP 0 866 497 A2

# FIG. 3
## (PRIOR ART)

RECEIVING INGOT

↓

ORIENTATION
MEASUREMENT

↓

SLICING   ←———— BONDING
  ↑
——→ SUPPORTING-PLATE-
REMOVING/CLEANING

↓

LAPPING

↓

SECONDARY CHAMFERING

↓

ETCHING

↓

EDGE POLISHING

↓

MIRROR POLISHING

↓

CLEANING

↓

QUALITY INSPECTION

↓

PACKAGING

↓

SHIPMENT